# EUROPÄISCHE PATENTSCHRIFT

(11) **EP 1 082 193 B1**
(45) Veröffentlichungstag und Bekanntmachung des Hinweises auf die Patenterteilung: **01.10.2003**
(21) Anmeldenummer: 99925016.0
(22) Anmeldetag: 20.05.1999
(51) Int. Cl.: B23Q 7/14, H01L 21/00

(54) **VERFAHREN UND EINRICHTUNG ZUR DURCHFÜHRUNG VON ARBEITSSCHRITTEN AN MINIATURISIERTEN BAUGRUPPEN**
METHOD AND DEVICE FOR CARRYING OUT WORKING STEPS ON MINIATURISED MODULES
PROCEDE ET DISPOSITIF POUR LA REALISATION D'ETAPES DE TRAVAIL SUR DES MODULES MINIATURISES

(30) Priorität: 23.05.1998 DE 19823196
(43) Veröffentlichungstag der Anmeldung: 14.03.2001
(73) Patentinhaber: Mi La Sys GbR, 71094 Weil im Schönbuch (DE)
(72) Erfinder: MENSCHIG, Arnd, D-71093 Weil im Schönbuch (DE)
(74) Vertreter: Beck, Jürgen, Dr. Dipl.-Phys.
(86) Internationale Anmeldenummer: EP9903465
(87) Internationale Veröffentlichungsnummer: WO99061200

(56) Entgegenhaltungen:
- DE-C- 19 637 822
- US-A- 4 946 021
- US-A- 5 092 729
- US-A- 5 332 013
- US-A- 5 736 464

## Beschreibung

Ein derartiges Verfahren zum Durchführen von Arbeitsschritten an miniaturisierten Baugruppen, die von einem mit einer Halteeinrichtung versehenen Baugruppenträger gehalten sind, in mindestens einer Arbeitsstation, wobei die Baugruppe mit dem Baugruppenträger zur Durchführung der Arbeitsschritte zu mehreren Arbeitsstationen gebracht wird und durch Relativbewegung zwischen dem Baugruppenträger und der jeweils einen der mehreren Arbeitsstationen zum Durchführen eines der Arbeitsschritte exakt positioniert wird und wobei für die Durchführung der Arbeitsschritte die Positionierung der Baugruppe gegenüber dem Baugruppenträger aufrecht erhalten wird.

Aus der US-A-5,736,464 sind das vorstehend beschriebene Verfahren und eine entsprechende Vorrichtung bekannt.

Das aus der US-A-5,736,464 bekannte Verfahren sieht mehrere Arbeitsstationen vor, allerdings war keine einfache und exakte Positionierung der Baugruppe möglich.

Aus der US-A-5,323,013 ist ein Handhabungsroboter für einen Reinraum bekannt, um Wafer zu handhaben und in einem Container zu plazieren.

Der Erfindung liegt ausgehend von der US-A-5,736,464 die Aufgabe zugrunde, ein Verfahren zu schaffen, welches die Durchführung einer Vielzahl von Bearbeitungsschritten mit einfacher und exakter Positionierung einer Baugruppe erlaubt.

Diese Aufgabe wird bei einem Verfahren der eingangs beschriebenen Art erfindungsgemäß dadurch gelöst, daß eine Position der Baugruppe relativ zum Baugruppenträger durch eine am Baugruppenträger angeordnete und eine Position der Baugruppe erfassende Positioniereinrichtung ermittelt wird und daß in einer Arbeitsstation eine gesteuerte Relativpositionierung zwischen Baugruppenträger und Arbeitsstation, oder Baugruppenträger und weiterer Baugruppe oder Arbeitsstation und Baugruppe geführt durch an diesen angeordnete Positionserkennungselemente, durchgeführt wird.

Der Vorteil der erfindungsgemäßen Lösung ist einerseits darin zu sehen, daß durch die vorgesehene Vielzahl von Arbeitsstationen auch die Zahl der möglichen Arbeitsschritte vervielfacht wird, daß trotz dieser Vielzahl von Arbeitsstationen aufgrund der exakten Positionierung des Baugruppenträgers zur jeweiligen Arbeitsstation jedoch eine Durchführung des jeweiligen Arbeitsschritts mit großer Genauigkeit möglich ist und daß diese Genauigkeit für den jeweiligen Arbeitsschritt noch dadurch verbessert wird, daß die Positionierung der Baugruppe gegenüber dem Baugruppenträger aufrecht erhalten wird und somit hierdurch bedingte Ungenauigkeiten ausgeschlossen werden.

Prinzipiell könnte die Positionierung der Baugruppe relativ zum Baugruppenträger auch dadurch aufrecht erhalten werden, daß der Baugruppenträger die Baugruppe für die jeweilige Bearbeitung in der jeweiligen Arbeitsstation ablegt, in diesem Fall wäre jedoch ein exaktes Fixieren der Baugruppe in der Arbeitsstation notwendig um anschließend wiederum mit derselben Genauigkeit die Baugruppe von dem Baugruppenträger wieder aufnehmen zu lassen. Abgesehen davon, daß eine exakte Fixierung in der jeweiligen Arbeitsstation einen erheblichen Aufwand bedeutet, ist andererseits trotzdem ein Wiederaufnehmen der Baugruppe durch den Baugruppenträger mit einem Verlust an Präzision verbunden.

Aus diesem Grund sieht eine besonders vorteilhafte Lösung vor, daß bei Durchführung einer Folge von Arbeitsschritten die Baugruppe stets von der Halteeinrichtung des Baugruppenträgers gehalten wird. Bei dieser Lösung wird somit keinerlei Präzision verloren, da die Baugruppe nach wie vor von der Halteeinrichtung gehalten wird und somit die einzelnen Arbeitsschritte in den einzelnen Arbeitsstationen keinerlei Verlust der Genauigkeit der Orientierung der Baugruppe relativ zum Baugruppenträger bedeuten.

Besonders günstig läßt sich eine derartige Durchführung von Arbeitsschritten bei vom Baugruppenträger gehaltener Baugruppe dann durchführen, wenn die Folge von Arbeitsschritten mechanisch berührungslos erfolgt, so daß an die Fixierung der Baugruppe relativ zum Baugruppenträger keine hohen Anforderungen gestellt werden und somit keine großen Kräfte wirken, die wiederum zu einer Verschiebung der Baugruppe relativ zum Baugruppenträger führen und somit die Genauigkeit negativ beeinflussen könnten.

Eine mechanische berührungslose Bearbeitung wäre mit unterschiedlichen Mitteln möglich. Beispielsweise wäre es denkbar, mittels Strahlen aus Elementarteilchen, Neutralteilchen oder Ionen eine mechanisch berührungslose Bearbeitung durchzuführen.

Besonders einfach durchführbar sind die Arbeitsschritte jedoch dann, wenn diese mittels elektromagnetischer Strahlung durchgeführt werden, da diese sich einfach erzeugen und für die einzelnen Arbeitsschritte einsetzen und beispielsweise fokussieren läßt.

Im Rahmen eines erfindungsgemäßen Arbeitsschrittes sind die unterschiedlichsten Funktionen denkbar, wobei hierunter alle Funktionen fallen können, die beispielsweise zu einer Fertigung einer miniaturisierten Baugruppe eingesetzt werden können.

Beispielsweise ist es denkbar, daß als einer der Arbeitsschritte eine Feinpositionierung der Baugruppe durchgeführt wird, um die nachfolgenden Bearbeitungen mit möglichst großer Präzision durchzuführen.

Besonders vorteilhaft hat es sich dabei erwiesen, daß beim Arbeitsschritt der Feinpositionierung eine exakte Position der Baugruppe relativ zum Baugruppenträger ermittelt und für nachfolgende Arbeitsschritte zur Verfügung gestellt wird. Damit besteht beispielsweise die Möglichkeit, aufgrund dieser exakten Position der Baugruppe relativ zum Baugruppenträger durch nachfolgende Positionierung des Baugruppenträgers zur jeweiligen Arbeitsstation zwangsläufig dieselbe Genauigkeit bei der Position der Baugruppe relativ zur Arbeitsstation zu erhalten.

Beispielsweise ist eine derartige Ermittlung der Position der Baugruppe relativ zum Baugruppenträger ähnlich einer Eichung durchführbar, das heißt es wird die Abweichung der Position der Baugruppe relativ zum Baugruppenträger von einer Idealposition ermittelt und damit auch die Positionierungen für die nachfolgenden Arbeitsschritte korrigiert.

Dieses Verfahren schafft die Möglichkeit, beim Greifen oder Aufnehmen der Baugruppe durch die Halteeinrichtung einen gewissen Positionierungsfehler zuzulassen, nachfolgend aber jedoch durch die Feinpositionierung zu ermitteln und dann wiederum bei allen nach folgenden Bearbeitungen zu berücksichtigen, so daß das eigentliche Aufnehmen der Baugruppe durch die Halteeihrichtung einfach gestaltet werden kann und hierbei keine allzu hohe Präzision eingehalten werden muß.

Außerdem ist es bei einem Ausführungsbeispiel von Vorteil, wenn in jeder Arbeitsstation eine gesteuerte Relativpositionierung zwischen Baugruppenträger und Arbeitsstation, geführt durch an diesen angeordnete Positionserkennungselemente durchgeführt wird, so daß damit stets eine sehr hohe Präzision bei dem nachfolgend durchzuführenden Arbeitsschritt eingehalten werden kann.

Hinsichtlich der Art der in einer Arbeitsstation vorgesehenen Arbeitsschritte wurden bislang keine näheren Angaben gemacht. So sieht ein vorteilhaftes Ausführungsbeispiel vor, daß in einer der Arbeitsstationen ausschließlich berührungslose Arbeitsschritte durchgeführt werden, so daß beispielsweise für alle in dieser Arbeitsstation durchgeführten Folge von Arbeitsschritten die Baugruppe stets von der Halteeinrichtung gehalten werden kann.

Besonders vorteilhaft ist es jedoch, wenn in mehreren der Arbeitsstationen ausschließlich berührungslose Arbeitsschritte durchgeführt werden.

Auch derart berührungslose Arbeitsschritte können beispielsweise unterschiedlichster Art sein, es wäre beispielsweise denkbar, als Arbeitsschritt ein Aufdampfprozeß mit einer konventionellen Aufheizung des aufzudampfenden Materials vorzusehen. Auch in diesem Fall ist es jedoch vorteilhaft, wenn der berührungslose Arbeitsschritt mittels elektromagnetischer Strahlung durchgeführt wird. Besonders homogen durchführbar sind die Arbeitsschritte jedoch dann, wenn diese mit elektromagnetischer Strahlung mit räumlich gleichmäßiger Energiedichteverteilung durchgeführt werden, da dann im gesamten Bearbeitungsbereich gleiche physikalische Wechselwirkungen stattfinden und auch eine reduzierende Projektion von komplexen Strukturen auf einer im Strahlengang befindlichen Maske möglich ist.

Besonders vorteilhaft ist es, wenn der berührungslose Arbeitsschritt mittels Laserstrahlung durchgeführt wird.

Ein besonders gleichmäßiger flächenhafter Abtrag oder Auftrag in den Arbeitsschritten ist dann durchführbar, wenn das Strahlprofil quadratisch oder rechteckig ausgebildet ist, da quadratische oder rechteckige Strahlprofile sich sehr einfach und paßgenau zu größeren Flächen zusammensetzen lassen.

Besonders präzise durchführbar sind die Arbeitsschritte jedoch dann, wenn diese mit gepulster elektromagnetischer Strahlung mit so kurzen Pulsen durchgeführt werden, daß während der Pulsdauer kein Energietransfer vom Elektronensystem in das Phononensystem des zu bearbeitenden Festkörpers transferiert wird.

Eine besonders hohe Präzision läßt sich dann erreichen, wenn der Arbeitsschritt mittels gepulster Laserstrahlung, vorzugsweise Laserstrahlung im Pikosekundenbereich oder Femtosekundenbereich durchgeführt wird, da mit derartigen Pulsen eine hohe Präzision jeglicher Art von Bearbeitung erreicht werden kann, aufgrund der Tatsache, daß bei Verwendung von Laserpulsen im Pikosekundenbereich Wärmeleitungseffekte, die sich negativ auf die Präzision der Bearbeitung mit Laserstrahlung auswirken, weitgehend vermieden werden.

Beispielsweise ist es denkbar, daß ein Schichtauftrag auf die Baugruppe mittels Laserstrahlung durchgeführt wird.

Alternativ ist es aber auch denkbar, daß ein Materialabtrag von der Baugruppe mit Laserstrahlung durchgeführt wird.

Eine weitere Möglichkeit eines Arbeitsschritts ist die Herstellung einer Fügeverbindung auf der Baugruppe mittels Energiezufuhr mit elektromagnetischer Strahlung, vorzugsweise ebenfalls gepulster Laserstrahlung.

Hinsichtlich der Bewegung des Baugruppenträgers zu den einzelnen Arbeitsstationen wurden bislang keine näheren Angaben gemacht. So sieht ein vorteilhaftes Ausführungsbeispiel vor, daß ein Baugruppenträger entsprechend einer festgelegten Folge von einer Arbeitsstation zur anderen bewegt wird.

Besonders effizient läßt sich dieses Verfahren jedoch dann noch weiterbilden, wenn nicht nur ein Baugruppenträger entsprechend einer festgelegten Folge von einer Arbeitsstation zu anderen bewegt wird, sondern mehrere Baugruppenträger, im Idealfall eine näherungsweise der Zahl der Arbeitsstationen entsprechende Vielzahl von Baugruppenträgern entsprechend einer festgelegten Folge von einer Arbeitsstation zur anderen bewegt wird, so daß mehrere Baugruppenträger gleichzeitig mit jeweils einer der mehreren Arbeitsstationen zusammenwirken.

Die festgelegte Folge kann dabei entweder fest vorgegeben oder vorzugsweise frei programmierbar sein.

Vorzugsweise ist zur Realisierung der Bewegbarkeit der Baugruppenträger von Arbeitsstation zu Arbeitsstation vorgesehen, daß die Baugruppenträger relativ zu einer Grundeinheit bewegbar sind, wobei vorzugsweise die Arbeitsstationen gegenüber der Grundeinheit feststehend angeordnet sind. Es besteht aber auch die Möglichkeit, zusätzlich zu den Baugruppenträgern auch noch die Arbeitsstationen relativ zu der Grundeinheit bewegbar anzuordnen.

Vorzugsweise sind die Baugruppenträger dabei auf der Grundeinheit entlang beliebig vorgebbarer Pfade bewegbar, so daß das erfindungsgemäße Verfahren eine größtmögliche Flexibilität zeigt.

Die Baugruppenträger lassen sich dabei besonders günstig dann bewegen, wenn diese berührungslos mit Steuerinformationen versorgt werden und beispielsweise auch berührungslos Meßdaten an die Zentraleinheit übermitteln.

Diese Steuerinformationen umfassen einerseits Informationen betreffend die durchzuführenden Arbeitsschritte.

Es ist aber auch denkbar, berührungslos Informationen über die auf der Grundeinheit durchzuführende Pfade berührungslos zu übermitteln.

Eine besonders günstige Lösung sieht dabei vor, daß die Baugruppenträger berührungslos positionsgesteuert werden, das heißt, daß eine berührungslose Positionserfassung der Baugruppenträger entlang ihrer Pfade auf der Grundeinheit erfolgt und somit auch der Weg der Baugruppenträger zwischen zwei Arbeitsstationen berührungslos steuerbar ist.

Eine weitere besonders günstige Lösung sieht vor, daß Meßdaten aus der Positionsbestimmung der Baugruppenträger berührungslos beispielsweise an die Zentraleinheit übermittelt werden.

Um die Baugruppenträger bei der Bewegung relativ zur Grundeinheit mit Energie zu versorgen, wäre es beispielsweise denkbar, die Energie über eine flexible Leitung zuzuführen. Besonders günstig ist es jedoch, wenn die Baugruppenträger berührungslos mit Energie versorgt werden, beispielsweise läßt sich hierbei die induktive Energieübertragung vorsehen, mit welcher die unmittelbar erforderliche Energie übertragen werden kann oder Energie übertragen werden kann, die in dem Baugruppenträger in einem Energiespeicher, beispielsweise einem Akkumulator, zwischengespeichert wird.

Darüber hinaus betrifft die Erfindung eine Einrichtung zur Durchführung von Arbeitsschritten an miniaturisierten Baugruppen, umfassend einen mit einer Halteeinrichtung zum Halten der Baugruppen versehenen Baugruppenträger und mehrere Arbeitsstationen zum Durchführen mindestens eines Arbeitsschritts, wobei der Baugruppenträger so bewegbar ist, daß bei den mehreren Arbeitsstationen die Baugruppe zur Durchführung der Arbeitsschritte durch Relativbewegung von Baugruppenträger und Arbeitsstation exakt positionierbar ist und daß die Baugruppe mit der Halteeinrichtung für die Durchführung der Arbeitsschritte in einer einzigen Relativposition zum Baugruppenträger fixierbar ist, und wobei eine Position der Baugruppe relativ zum Baugruppenträger durch eine am Baugruppenträger angeordnete und eine Position der Baugruppe erfassende Positioniereinrichtung ermittelbar ist und wobei in einer Arbeitsstation eine gesteuerte Relativpositionierung zwischen Baugruppenträger und Arbeitsstation, oder Baugruppenträger und weiterer Baugruppe oder Arbeitsstation und Baugruppe geführt durch an diesen angeordnete Positionserkennungselemente durchführbar ist.

Mit dieser Lösung ist die Möglichkeit geschaffen, auch bei miniaturisierten Baugruppen eine Vielzahl von Fertigungsschritten einerseits effizient und andererseits mit Hochpräzision durchzuführen.

Vorzugsweise ist dabei vorgesehen, daß die Baugruppe an einem Greiferkopf als Halteeinrichtung des Baugruppenträgers fixierbar ist.

Der Greifer kann dabei unterschiedlichster Art und Weise ausgebildet sein. Beispielsweise wäre es möglich, den Greifer als Elektrostatikgreifer auszubilden, welcher mittels eines Elektrostatikantriebs die Baugruppe mechanisch greift. Eine besonders einfache Art des Aufbaus sieht jedoch vor, daß der Greiferkopf einen Vakuumgreifer für die Baugruppe aufweist, mit welcher die Baugruppe durch ein Vakuum gegen eine Anlagefläche gezogen und kraftschlüssig fixiert wird.

Um beim Aufnehmen der Baugruppe eine zumindest ausreichend genaue Vorpositionierung der Baugruppe relativ zum Vakuumgreifer durchführen zu können, ist vorzugsweise vorgesehen, daß in dem Vakuumgreifer eine Positioniereinrichtung für die Baugruppe integriert ist, mit welcher ein positionspräzises Greifen der Baugruppe möglich ist.

Die Positioniereinrichtung könnte dabei beispielsweise so ausgebildet sein, daß sie die Form der Baugruppe erkennt und den Vakuumgreifer entsprechend ausrichtet, um dann auf die Baugruppe zuzugreifen, wobei dieses Zugreifen nach einem Ausrichten des Vakuumgreifers "blind" erfolgen kann. Noch vorteilhafter ist es jedoch, wenn die Positioniereinrichtung eine einer Vakuumkammer des Vakuumgreifers zugeordnete Markierung auf der Baugruppe erkennend ausgebildet ist, da in diesem Fall noch während des Zugreifens des Vakuumgreifers auf die Baugruppe die Position der Markierung erfaßt und somit auch noch während des Zugreifens der Vakuumgreifer gesteuert werden kann, um die Baugruppe möglichst exakt zu greifen.

Um ferner bei einer einmal gegriffenen Baugruppe die Möglichkeit zu haben, diese wiederum zu der jeweiligen Arbeitsstation exakt zu positionieren ist vorzugsweise vorgesehen, daß der Greiferkopf und jede Arbeitsstation miteinander zusammenwirkende Positionserkennungselemente aufweisen, mit welchen der Greiferkopf exakt zur Arbeitsstation positionierbar ist. Diese Lösung bietet die Chance, einerseits die Baugruppe relativ zum Greiferkopf exakt zu positionieren und andererseits danach durch eine exakte Positionierung jeweils des Greiferkopfs zur Arbeitsstation auch gleichzeitig eine exakte Positionierung der Baugruppe zur Arbeitsstation zu erhalten.

Um den Baugruppenträger relativ zu den einzelnen Arbeitsstationen bewegen zu können ist vorzugsweise vorgesehen, daß der Baugruppenträger eine Antriebseinheit aufweist, mit welcher dieser relativ zur Grundeinheit bewegbar ist. Eine derartige Antriebseinheit kann unterschiedlichster Art und Weise ausgebildet sein.

Beispielsweise wäre es denkbar, hierzu einen Radantrieb vorzusehen. Es ist aber auch vorteilhaft, einen elektromagnetischen, elektrostatischen oder pneumatischen direktangetriebenen Linearmotor zum Bewegen des Baugruppenträgers vorzusehen.

Ferner ist vorzugsweise vorgesehen, daß der Baugruppenträger eine Koppeleinheit aufweist, mit welcher Energie in den Baugruppenträger, beispielsweise auf induktivem Wege, einkoppelbar ist.

Vorzugsweise ist dabei die Koppeleinheit jeweils einer Arbeitsstation zugeordnet, so daß bei Positionierung des Baugruppenträgers nahe der jeweiligen Arbeitsstation automatisch die Koppeleinheit für die Einkopplung der für die Funktionen des Baugruppenträgers erforderlichen Energie sorgt.

Darüber hinaus ist vorzugsweise auch die Koppeleinheit dazu einsetzbar, eine Grobpositionierung des Baugruppenträgers auf der Grundeinheit relativ zur jeweiligen Arbeitsstation vorzusehen.

Um eine exakte Positionierung des Greiferkopfes relativ zu der jeweiligen Arbeitsstation durchführen zu können, ist vorzugsweise vorgesehen, daß der Baugruppenträger Positioniereinheiten aufweist, mit welchen der Greiferkopf relativ zu einem Grundelement des Baugruppenträgers bewegbar ist. Mit dieser Positioniereinheit läßt sich dann die exakte Positionierung der Baugruppe relativ zur jeweiligen Arbeitsstation vornehmen.

Ein besonders vorteilhaftes Konzept eines erfindungsgemäßen Baugruppenträgers sieht vor, daß dieser ein Grundelement und einen den Greiferkopf tragenden Ausleger aufweist, wobei vorzugsweise die Positioniereinheiten zwischen dem Grundelement und dem Ausleger wirksam sind und somit über den Ausleger auch den Greiferkopf selbst exakt positionieren.

Um die verschiedenen Funktionen des Baugruppenträgers in einfacher Weise steuern zu können, ist vorgesehen, daß der Baugruppenträger eine Steuerung aufweist, mit welcher der Greiferkopf relativ zum Grundelement exakt positionierbar ist.

Ferner ist, insbesondere um mehrere Baugruppenträger gemeinsam steuern zu können, vorgesehen, daß die Steuerung des Baugruppenträgers mit einer Gesamtsteuerung der erfindungsgemäßen Einrichtung kommuniziert, die in der Lage ist, die Bewegungen der mehreren Baugruppenträger miteinander zu koordinieren.

Vorzugsweise ist dabei vorgesehen, daß die Steuerung mittels berührungsloser Informationsübertragung mit der Gesamtsteuerung kommuniziert.

Hinsichtlich der Ausbildung der Arbeitsstationen im einzelnen wurden bislang ebenfalls keine näheren Angaben gemacht. So sieht eine vorteilhafte Lösung vor, daß eine der Arbeitsstationen mit einer Laserstrahlungsquelle versehen ist, mit welcher die zur Durchführung der Arbeitsschritte in dieser erforderliche Laserstrahlung erzeugbar ist.

Für eine Bearbeitung zur Fertigung miniaturisierter Baugruppen mit großen Stückzahlen und hohem Durchsatz ist dabei vorzugsweise jede der Arbeitsstationen, welche mit Laserstrahlung arbeitet, mit einer eigenen Laserstrahlungsquelle versehen.

Für eine Bearbeitung zur Fertigung miniaturisierter Baugruppen als Prototypen, Gebrauchsmuster oder in kleinen und mittleren Stückzahlen ist dabei vorzugsweise jede der Arbeitsstationen, welche mit Laserstrahlung arbeitet, mit derselben Laserstrahlungsquelle durch umschaltbare Strahlweichen versorgt.

Vorzugsweise ist die Arbeitsstation zur Laserbearbeitung der Baugruppe so ausgebildet, daß die Laserstrahlung aus einer einer in dieser Arbeitsstation positionierten Baugruppe zugewandten Austrittsöffnung austritt und somit mit der Laserstrahlung unmittelbar eine Bearbeitung der Baugruppe möglich ist oder auch ein Auftragen von Material auf dieser Baugruppe, wobei dieses Material zum Auftragen zwischen der Austrittsöffnung für die Laserstrahlung und der Baugruppe positionierbar ist.

Vorzugsweise ist das Material zum Auftragen auf einem transparenten Träger als vorstrukturierter, dünner Film aufgebracht, wobei erreicht wird, daß ein geometriegetreues Übertragen der vorstrukturierten Filme gelingt.

Vorzugsweise ist dabei die Laserstrahlungsquelle so ausgebildet, daß sie gepulste Laserstrahlung erzeugt, besonders günstig ist es, wenn die Laserstrahlungsquelle Laserstrahlung mit Pulsdauern im Pikosekundenbereich oder Femtosekundenbereich erzeugt.

Um besonders homogene Bearbeitungen oder auch einen homogenen Auftrag eines auf der Baugruppe zu positionierenden Elements vornehmen zu können, ist vorzugsweise vorgesehen, daß die Laserstrahlungsquelle Pulse mit räumlich homogener Energiedichte (hat-top-Profil) erzeugt.

Um besonders gleichmäßige Bearbeitungen oder auch einen präzisen Auftrag eines auf der Baugruppe zu positionierenden Elements vornehmen zu können, ist vorzugsweise vorgesehen, daß die Laserstrahlungsquelle Pulse mit einem rechteckigen Strahlprofil erzeugt.

Weitere Merkmale und Vorteile der erfindungsgemäßen Lösung sind Gegenstand der nachfolgenden Beschreibung sowie der zeichnerischen Darstellung eines Ausführungsbeispiels der erfindungsgemäßen Lösung.

In der Zeichnung zeigen:
- Fig. 1: eine Seitenansicht einer erfindungsgemäßen Einrichtung;
- Fig. 2: eine vergrößerte schematische Darstellung eines Schnitts durch einen erfindungsgemäßen Greiferkopf;
- Fig. 3: eine teilweise geschnittene Seitenansicht eines erfindungsgemäßen Baugruppenträgers;
- Fig. 4, umfassend Fig. 4a + 4b:: einen Schnitt durch den Greiferkopf im Zusammenhang mit dem Aufnehmen einer Baugruppe in einer erfindungsgemäßen Aufnahmestation;
- Fig. 5: einen Schnitt durch den Greiferkopf im Zusammenhang mit der Durchführung einer Feinpositionierung der Baugruppe in einer erfindungsgemäßen Meßstation;
- Fig. 6: einen Schnitt durch den Greiferkopf im Zusammenhang mit der Durchführung eines Materialabtrags einer erfindungsgemäßen Abtragstation;
- Fig. 7: eine schematische Darstellung einer erfindungsgemäßen Strahlformungsoptik;
- Fig. 8: einen Schnitt durch den Greiferkopf im Zusammenhang mit der Darstellung einer Beschichtung der Baugruppe in einer erfindungsgemäßen Beschichtungsstation;
- Fig. 9, umfassend Fig. 9a - 9c: einen Schnitt durch den Greiferkopf im Zusammenhang mit der Montage der erfindungsgemäßen Baugruppe auf einer Grundbaugruppe.

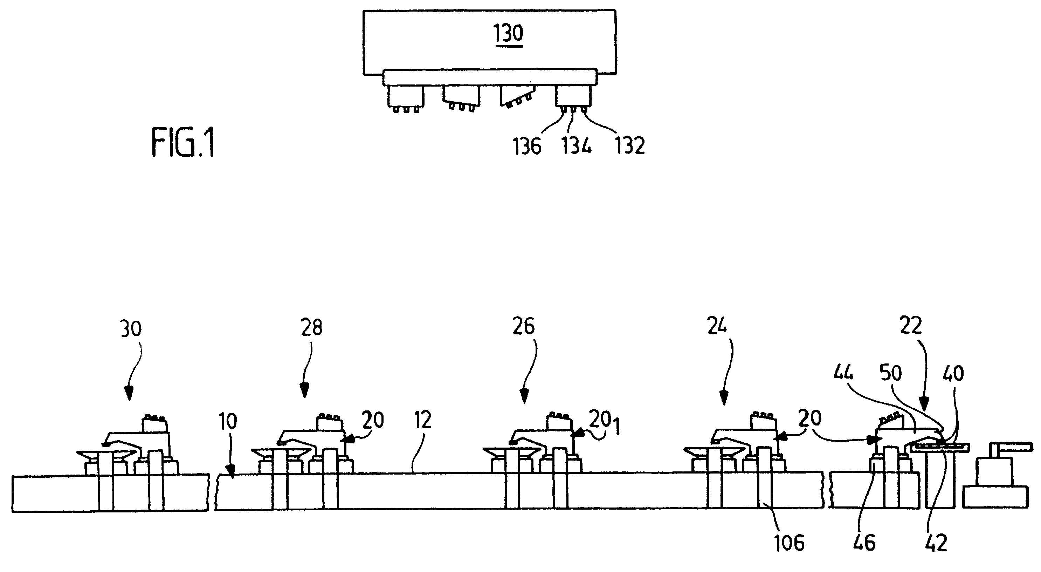

Ein Ausführungsbeispiel einer erfindungsgemäßen Einrichtung zum Herstellen und/oder Bearbeiten miniaturisierter Baugruppen umfaßt, wie in Fig. 1 dargestellt, eine als Ganzes mit 10 bezeichnete Grundeinheit, welche eine Basis für mehrere auf dieser angeordnete Baugruppenträger 20 bildet, die auf einer Oberfläche 12 der Grundeinheit 10 bewegbar angeordnet sind.

Ferner sind bezüglich der Grundeinheit 10 feststehend angeordnete Arbeitsstationen vorgesehen, die beispielsweise durch eine Aufnahmestation 22, eine Meßstation 24, eine Abtragstation 26, eine Beschichtungsstation 28 und eine Montagestation 30 repräsentiert werden, deren Funktion nachfolgend im einzelnen erläutert wird.

In der Aufnahmestation 22 besteht für einen der Baugruppenträger 20 die Möglichkeit, eine erfindungsgemäß zu bearbeitende Baugruppe 40 von einem beispielsweise mit 42 bezeichneten und als Magazin ausgebildeten Tisch aufzunehmen.

Zum Halter einer Baugruppe 40 ist jeder der Baugruppenträger 20 mit einem Ausleger 44 versehen, welcher sich ausgehend von einem Fuß 46 als Grundelement des Baugruppenträgers 20 in einer Richtung erstreckt und an seinem vorderen Ende eine Halteeinrichtung 48 trägt.

Mit dieser Halteeinrichtung 48 ist eine der Baugruppen 40 auf dem Tisch 42 liegend greifbar und durch Anheben des Auslegers 44 gegenüber dem Fuß 46 von dem Tisch 42 abhebbar.

Nach der Aufnahme der Baugruppe 40 durch die Halteeinrichtung 48 und Abheben derselben vom Tisch 42 erfolgen weitere Arbeitsschritte in der Meßstation 24, der Abtragstation 26, der Beschichtungsstation 28 und der Montagestation 30, die im nachfolgenden im einzelnen beschrieben werden.

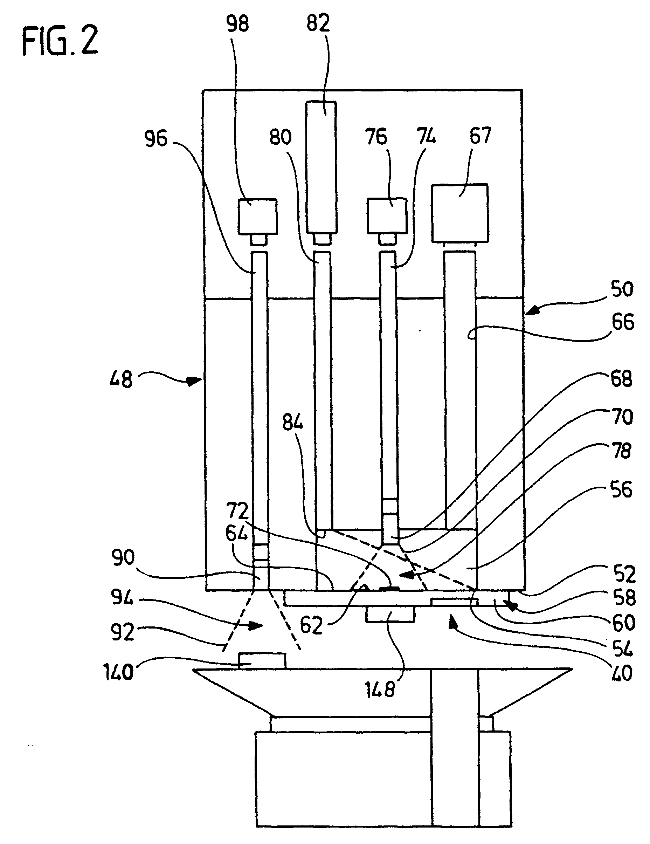

Wie in Fig. 2 im einzelnen dargestellt, umfaßt die als Ganzes mit 48 bezeichnete Halteeinrichtung einen Greiferkopf 50, beispielsweise aufgebaut gemäß dem in der DE 196 37 822 C1 offenbarten Greiferkopf, welcher mit einer Anlagefläche 52 eines Vakuumgreifers 53 für die miniaturisierte Baugruppe 40 versehen ist.

Die Anlagefläche 52 ist beispielsweise als Planfläche ausgebildet und in diese mündet eine Öffnung 54 einer als Ganzes mit 56 bezeichneten Vakuumkammer des im Greiferkopf 50 angeordneten Vakuumgreifers 53 , so daß sich die Anlagefläche 52 im wesentlichen um die Öffnung 54 der Vakuumkammer 56 herum erstreckt.

Die Öffnung 54 ist dabei vorzugsweise so dimensioniert, daß eine Grundplatine 58 der Baugruppe 40 mindestens mit einem Randbereich 60 über die Öffnung 54 randseitig übersteht und somit an der Auflagefläche 52 die Öffnung 54 umschließend anlegbar ist.

Die im Greiferkopf 50 liegende Vakuumkammer 56 ist somit einem Zentralbereich 62 der Grundplatine 58 zugewandt und erstreckt sich bei an der Auflagefläche 52 mit dem Randbereich 60 anliegender Grundplatine 58 hinter einer Rückseite 64 der Grundplatine 58 in den Greiferkopf 50 hinein.

Zum Erzeugen eines Vakuums in der Vakuumkammer 56 ist diese mit einem Vakuumanschlußkanal 66 verbunden, der zu einer zeichnerisch nicht dargestellten und in dem jeweiligen Baugruppenträger 20 vorgesehenen Vakuumerzeugungseinheit 67 führt.

Beispielsweise liegt der Vakuumanschlußkanal 66 so, daß er randseitig an einer Stelle in die Vakuumkammer 56 mündet.

In die Vakuumkammer 56 hinein ragt eine Abbildungsoptik 68, mit welcher eine innerhalb eines durch den Öffnungswinkel 70 definierten Erfassungsbereichs 78 derselben liegende Markierung 72 der Grundplatine 58 beobachtbar ist, wobei die Markierung 72 entweder auf der Rückseite 64 angeordnet ist oder bei transparenter Grundplatine 58 auch auf deren Vorderseite angeordnet sein kann.

Hierzu steht die Abbildungsoptik 68 auf ihrer der Markierung 72 gegenüberliegenden Seite mit einem Bildleiter 74 in Verbindung, welcher zu einer als Ganzes mit 76 bezeichneten Kamera, beispielsweise einer CCD-Kamera führt, mit welcher die Markierung 72 beobachtbar und deren Orientierung erkennbar ist.

Die Abbildungsoptik 68 liegt dabei so, daß deren den Erfassungsbereich 78 definierender Öffnungswinkel 70, die Rückseite 64 der Grundplatine 58, und zwar in dem Zentralbereich 62 derselben, übergreift, sofern die Grundplatine 58 mit ihren Randbereichen 60 an der Auflagefläche 52 anliegt.

Um die Markierung 72 der Grundplatine 58 beobachten zu können, mündet ferner in die Vakuumkammer 56, wie in Fig. 2 ebenfalls dargestellt, ein Lichtleiter 80, welcher ausgehend von einer Lichtquelle 82 in den Greiferkopf 50 geführt ist und mit seinem vorderen Ende 84 so ausgerichtet ist, daß mit diesem die Rückseite 64 und insbesondere die Markierung 72 auf der Grundplatine 58 ausleuchtbar ist.

Darüber hinaus ist in dem Greiferkopf 50 noch eine Abbildungsoptik 90 vorgesehen, die so angeordnet ist, daß sie bei an der Auflagefläche 52 mit den Randbereichen 60 anliegender Grundplatine 58 von dieser nicht verdeckt ist, sondern deren Öffnungswinkel 92 einen Beobachtungsbereich 94 definiert, welcher neben der am Greiferkopf 50 gehaltenen Grundplatine 58 liegt und mit welchem, wie später noch im einzelnen erläutert, eine Markierung in einer der Arbeitsstationen beobachtbar ist.

Hierzu ist die Abbildungsoptik 90 auf ihrer dem Beobachtungsbereich 94 gegenüberliegenden Seite ebenfalls mit einem Bildleiter 96 verbunden, der zu einer Kamera 98, vorzugsweise ebenfalls als CCD-Kamera ausgebildet, führt, wobei mit dieser CCD-Kamera im Beobachtungsbereich 94 liegende Markierungselemente erfaßbar sind.

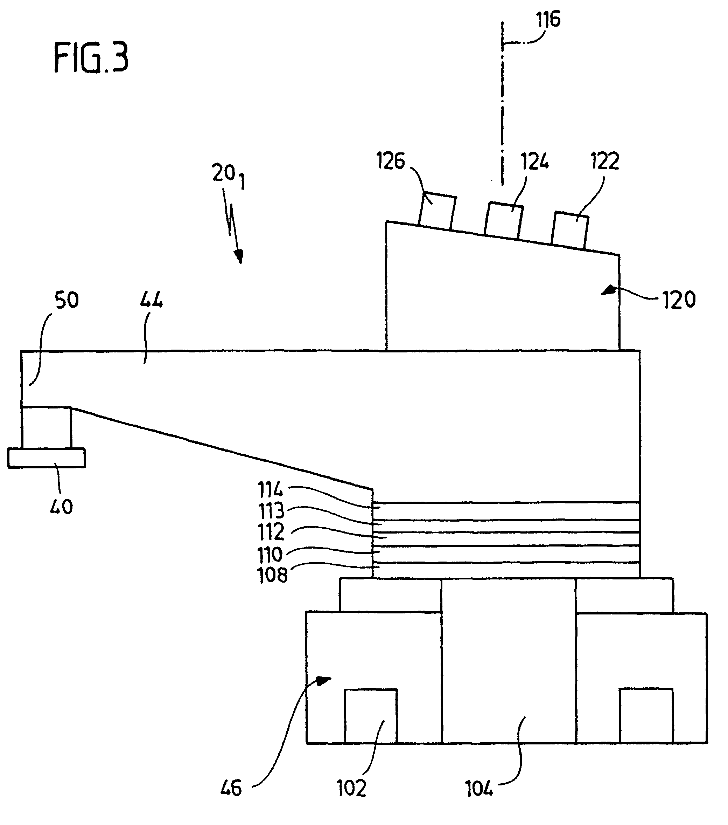

Wie in Fig. 3 dargestellt, ist bei jedem der Baugruppenträger 20 in dem Fuß 46 einerseits eine Antriebseinheit 102 vorgesehen, welche mit der Grundeinheit 10 derart wechselwirkt, daß ein Verschieben des jeweiligen Baugruppenträgers 20 auf der Grundeinheit 10 möglich ist. Beispielsweise funktioniert die Antriebseinheit 102 nach dem Prinzip eines Linearmotors.

Ferner ist in dem Fuß 46 eine Koppeleinheit 104 vorgesehen, über welche beispielsweise Energie von der Grundeinheit einkoppelbar ist, wobei die Grundeinheit 10 hierzu an speziell hierzu vorgesehenen Stellen eine stationäre Koppeleinrichtung 106 aufweist, welche mit der Koppeleinheit 104 im Fuß 46 des jeweiligen Baugruppenträgers zusammenwirkt.

Um den Greiferkopf 50 relativ zum Fuß 46 bewegen zu können, sind eine X-Verschiebeeinheit 108, eine Y-Verschiebeeinheit 110 und eine Hubeinheit 112 vorgesehen, welche so zusammenwirken, daß sie eine Feineinstellung des Auslegers 44 und somit des Greiferkopfes 50 relativ zum Fuß 46 in Form einer dreidimensionalen Bewegung erlauben.

Ferner ist noch eine optimale Ausrichtung der Baugruppe 40 in jeder Lage dann erreichbar, wenn zusätzlich zur X-Verschiebeeinheit 108, zur Y-Verschiebeeinheit 110 und zur Hubeinheit 112 noch eine X/Y Kippeinheit 113 und/oder eine Dreheinheit 114 vorgesehen ist, welche eine Rotation des Auslegers 40 um eine beispielsweise quer oder vorzugsweise senkrecht zur Oberfläche 12 der Grundeinheit 10 verlaufenden Achse 116 zu ermöglichen.

Vorzugsweise dient die Koppeleinheit 104 gemeinsam mit der Koppeleinrichtung 106 der Grundeinheit 10 nicht nur ausschließlich zur Einkopplung von Energie in den jeweiligen Baugruppenträger 20, sondern auch gleichzeitig zu einer Grobpositionierung des Fußes 46 des jeweiligen Baugruppenträgers 20 relativ zur Grundeinheit 10, um ausgehend von dieser Grobpositionierung dann mit der X-Verschiebeeinheit 108, der Y-Verschiebeeinheit 110, der Hubeinheit 112, der X/Y Kippeinheit 113 und der Dreheinheit 114 eine Feinpositionierung der Baugruppe 40 relativ zur jeweiligen Arbeitsstation zu erreichen.

Zur Steuerung einerseits der Bewegung des gesamten Baugruppenträgers 20 mittels der Antriebseinheit 102 relativ zur Grundeinheit 10 und andererseits zur Steuerung der Bewegung des Auslegers 44 mit dem Greiferkopf 50 ist eine als Ganzes mit 120 bezeichnete Steuerung in jedem Baugruppenträger 20 vorgesehen. Die Steuerung 120 kann dabei vorzugsweise über einzelne Sende- und Empfangseinrichtungen 122, 124 und 126 mit einer Gesamtsteuerung 130 der erfindungsgemäßen Einrichtung wechselwirken, welche ebenfalls mit entsprechenden Sende- und Empfangseinrichtungen 132, 134 und 136 versehen ist, die mit den Sende- und Empfangseinrichtungen 122, 124 und 126 der Steuerung 120 in Wechselwirkung treten, um Signale zur Koordinierung der von der Steuerung 120 durchzuführenden Funktionen mit der Gesamtsteuerung 130 auszutauschen.

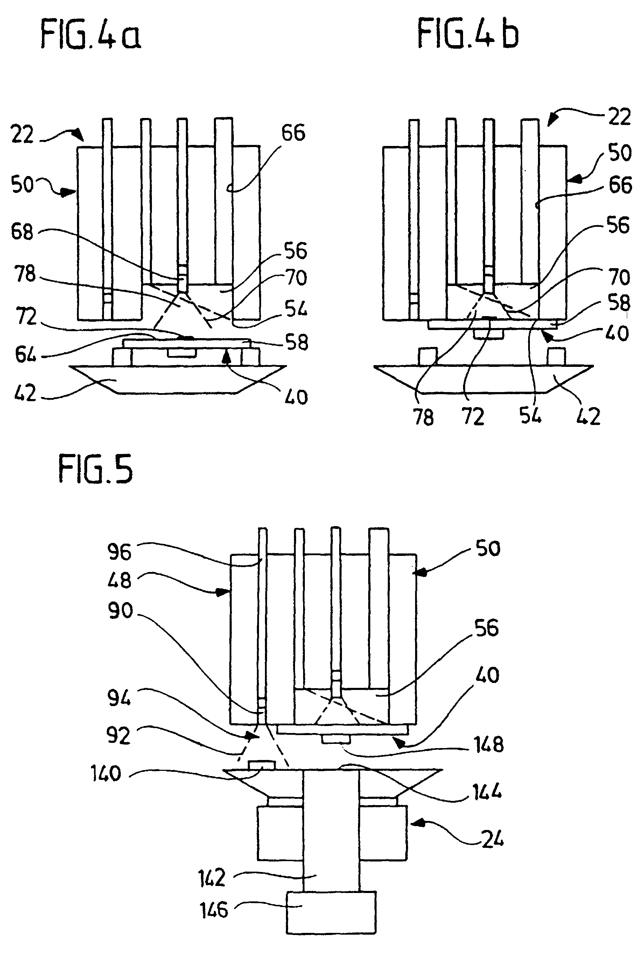

Somit ist es möglich, daß die Gesamtsteuerung 130 die Steuerung 120 eines der Baugruppenträger, beispielsweise des Baugruppenträgers 20₁ beispielsweise dazu veranlaßt, daß dieser Baugruppenträger sich relativ zur Grundeinheit zur Aufnahmestation 22 bewegt und, wie in Fig. 4b dargestellt, dort eine Baugruppe 40 greift.

Hierzu wird, wie in Fig. 4a schematisch dargestellt, der Greiferkopf 50 durch Ansteuern der X-Verschiebeeinheit 108, der Y-Verschiebeeinheit 110 und der Dreheinheit 114 sowie der Hubeinheit 112 so über der zu greifenden Baugruppe 40 positioniert, daß in dem Erfassungsbereich 78 der Abbildungsoptik 68 die Markierung 72 auf der Grundplatine 58 erkennbar ist.

Bereits aufgrund der Lage und Orientierung der Markierung 72 ist eine Positionierung des Greiferkopfes 50 relativ zur Baugruppe 40 möglich, die auch eine derartige Orientierung des Greiferkopfes 50 erlaubt, daß bei einem Bewegen desselben mittels der Hubeinheit 112 in Richtung auf die Grundplatine 58 die Randbereiche 60 derselben an den Auflageflächen 52 zur Anlage kommen. Nach Aufsetzen des Greiferkopfes 50 auf der auf dem Tisch 42 ruhenden Grundplatine 58 schließen die Randbereiche 60 durch Kontakt mit der Auflagefläche 52 an mindestens zwei Seiten der Öffnung 54 der Vakuumkammer 56 ab, so daß durch Anlegen eines Vakuums in der Vakuumkammer 56-ein kraftschlüssiges Festhalten der Grundplatine 58 durch festes Anlegen derselben an der Auflagefläche 52 des Greiferkopfes 50 erfolgt.

Wird nachfolgend der Greiferkopf 50 wieder angehoben, wie in Fig. 4b dargestellt, so kann die gesamte Baugruppe 40 insbesondere mit der Grundplatine 58, von dem Greiferkopf 50 gehalten und vom Tisch 42 weggetragen werden. Dabei besteht nach wie vor die Möglichkeit, mittels der Kamera 76 einerseits das Vorhandensein der gegriffenen Grundplatine 58 am Greiferkopf 50 und andererseits die Lage der Markierung 72 im Erfassungsbereich 78 weiter zu beobachten und zu überprüfen.

Eine derart von dem Baugruppenträger 20₁ gegriffene und gehaltene Baugruppe 40 läßt sich beispielsweise durch Verfahren des gesamten Baugruppenträgers 20 mittels der Antriebseinheit 102 relativ zur Grundeinheit 10 zu der nächsten Arbeitsstation, das heißt der Meßstation 24, bewegen.

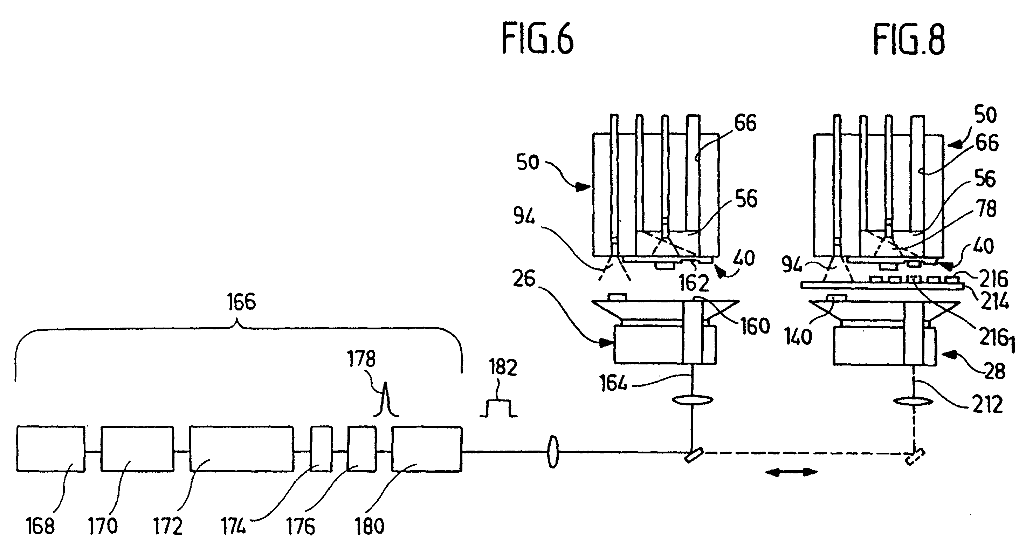

In der Meßstation 24 erfolgt, wie in Fig. 5 dargestellt, zunächst eine exakte Relativpositionierung des Greiferkopfes 50 zu der Meßstation 24 selbst.

Hierzu ist die Meßstation 24 mit einer Positionsmarkierung 140 versehen, welche dann, wenn sie im Beobachtungsbereich 94 der Kamera 98 liegt, der Steuerung 120 erlaubt, durch exakte Beobachtung der Positionsmarkierung 140 den Greiferkopf in einer exakten Position relativ zur Meßstation 24 anzuordnen. Damit wird zwangsläufig auch eine exakte Anordnung der Baugruppe 40 relativ zur Meßstation 24 möglich, wobei die Baugruppe 40 vom Greiferkopf durch das Vakuum in der Vakuumkammer 56 weiterhin gehalten wird.

Ausgehend von dieser exakten Positionierung läßt sich dann über eine in der Meßstation 24 vorgesehene Beobachtungsoptik 42 mit einer der Baugruppe 40 zugewandt liegenden Beobachtungsseite 144 und einer an dem der Beobachtungsseite 144 gegenüberliegenden Ende der Beobachtungsoptik 142 angeordneten Kamera 146 die genaue Lage der Baugruppe 40 bei exakter Positionierung des Greiferkopfes 50 relativ zur Meßstation 24 erfassen und vermessen. Beispielsweise ist hierzu jede Baugruppe 40 mit einer Meßmarkierung 148 versehen, deren Position von der Kamera 146 über die Beobachtungsoptik 142 exakt erfaßbar ist, wobei nicht nur eine exakte Erfassung der Meßmarkierung 148 in der zur Oberfläche 12 ungefähr parallelen X/Y-Ebene erfolgt, sondern gleichzeitig ein exaktes Erfassen eines Abstandes der Baugruppe 40 von der Beobachtungsseite 144, so daß eine Eichung hinsichtlich der exakten relativen Lage der Baugruppe 40 zur Meßstation 24 möglich ist.

Alternativ zur Festlegung der Lage der Meßmarkierung 148 der Baugruppe 40 wäre es ebenfalls denkbar, mittels der Kamera 146 und der Beobachtungsoptik 142 die Ausdehnung der Grundplatine 58 der Baugruppe zu erfassen, sofern sich Form und Größe der Grundplatine 58 nicht exakt vorgeben lassen.

Damit läßt sich auch eine Eichung der Relativposition der Baugruppe 40 bezüglich der Positionsmarkierung 140, beobachtet mit der Kamera 98, vornehmen. Diese Eichung läßt sich in allen weiteren Arbeitsstationen wieder verwenden, um exakt die Baugruppe 40 relativ zu den einzelnen Arbeitsstationen positionieren zu können, sofern die Relativposition der Baugruppe 40 zum Greiferkopf 50 erhalten bleibt.

Nach der exakten Vermessung der Baugruppe 40 in der Meßstation 24 läßt sich über die Gesamtsteuerung 130 und die Steuerung 120 der Baugruppenträger 20₁ weiter so steuern, daß er sich zur Abtragstation 26 bewegt.

In der Abtragstation 26 erfolgt ebenfalls wiederum eine exakte Positionierung des Greiferkopfes 50 relativ zur Abtragstation 26 mittels einer in gleicher Weise wie in der Meßstation angeordneten Positionsmarkierung 140, welche über den Beobachtungsbereich 94 mit der Kamera 98 erkennbar ist. Damit läßt sich nicht nur der Greiferkopf 50 relativ zur Positionsmarkierung 140 exakt positionieren, sondern auch gleichzeitig eine Korrektur einer gegebenenfalls nicht exakten Relativpositionierung der Baugruppe 40 relativ zum Greiferkopf vornehmen, wobei die Korrektur der an der Meßstation 24 vorgenommenen Eichung entspricht.

Mit dieser exakten Positionierung der Baugruppe 40 relativ zur Abtragstation 26 ist auch eine exakte Positionierung einer Austrittsöffnung 160 für Laserstrahlung in der Abtragstation 26 relativ zu einem Flächenbereich 162 möglich, in welchem ein Materialabtrag erfolgen soll, wobei durch die exakte Positionierung der Flächenbereich 162 genau gegenüberliegend der Austrittsöffnung 160 positioniert wird.

Aus der Austrittsöffnung 160 tritt vorzugsweise eine zum berührungslosen Materialabtrag geeignete Laserstrahlung 164 aus, welche durch eine als Ganzes mit 166 bezeichnete Laserstrahlungsquelle erzeugbar ist. Diese Laserstrahlungsquelle 166 weist beispielsweise einen Pumplaser 168 auf, mit welchem ein Faserlaser 170 gepumpt wird, dem außerdem noch ein Verstärker 172 nachgeschaltet ist, wobei der Laser 170 und der Verstärker 172 Laserpulse mit Pulsdauern im Bereich von vorzugsweise Pikosekunden erzeugen. Dem Verstärker 172 ist eine Leistungssteuereinheit 174 nachgeordnet, auf welche eine Pulsselektion 176 erfolgt, mit welcher einzelne Laserpulse 178 selektiert werden können, wobei diese Laserpulse 178, wie schematisch in Fig. 6 dargestellt, beispielsweise ein Gauss-förmiges Strahlprofil aufweisen.

Da ein Gauss-förmiges Strahlprofil bei dem Abtrag von Material im Flächenbereich 162 aufgrund der sehr ungleichmäßigen Energieverteilung zu Problemen führen würde, ist vorzugsweise eine Strahlformungsoptik 180 vorgesehen, mit welcher aus dem Laserpuls 178 mit Gauss-förmigem Strahlprofil ein Laserpuls 182 erzeugbar ist, welcher ein im wesentlichen rechteckförmiges Strahlprofil oder Hat-Top-förmiges Strahlprofil des Laserpulses 182 erzeugbar ist.

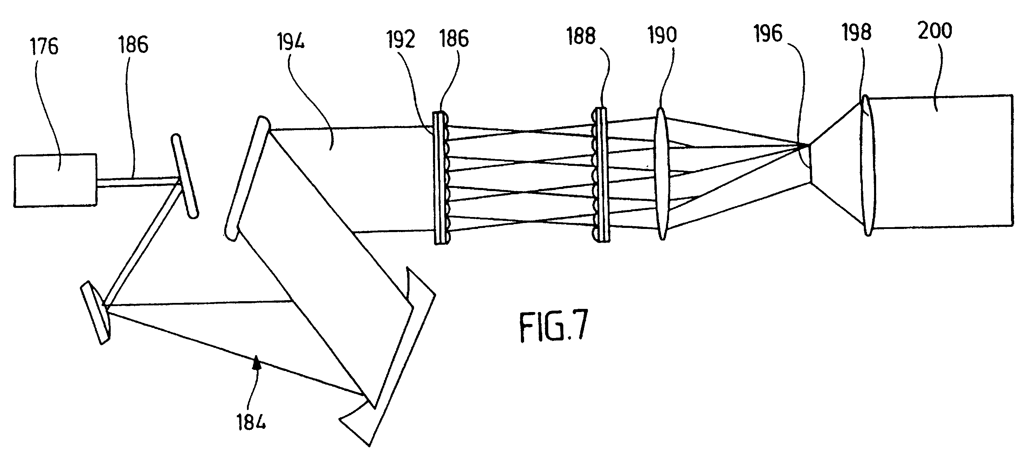

Eine derartige Strahlformungsoptik 180 ist beispielsweise in Fig. 7 exemplarisch dargestellt.

Diese umfaßt zunächst ein Teleskop 184, welches die von der Pulsselektion 176 kommende Laserstrahlung 186 aufweitet. Anschließend wird über zwei Mikrolinsenanordnungen 186 und 188 und eine nachgeschaltete Sammellinse 190 erreicht, daß einzelne Segmente 192 der aufgeweiteten Laserstrahlung 194 auf einen Bildfleck 196 übereinanderliegend abgebildet werden, wobei der Bildfleck 196 die Form des Bildes eines der Segmente 192 aufweist, die alle in dem Bildfleck 196 übereinanderllegen. Dadurch wird erreicht, daß die Summe der einander überlagerten Leistungen aus allen Strahlsegmenten 192 ungefähr gleich groß ist, so daß durch weitere Abbildung mittels einer Sammellinse 198 die Laserstrahlung 200 erhältlich ist, welche das gewünschte rechteckförmige Strahlprofil aufweist.

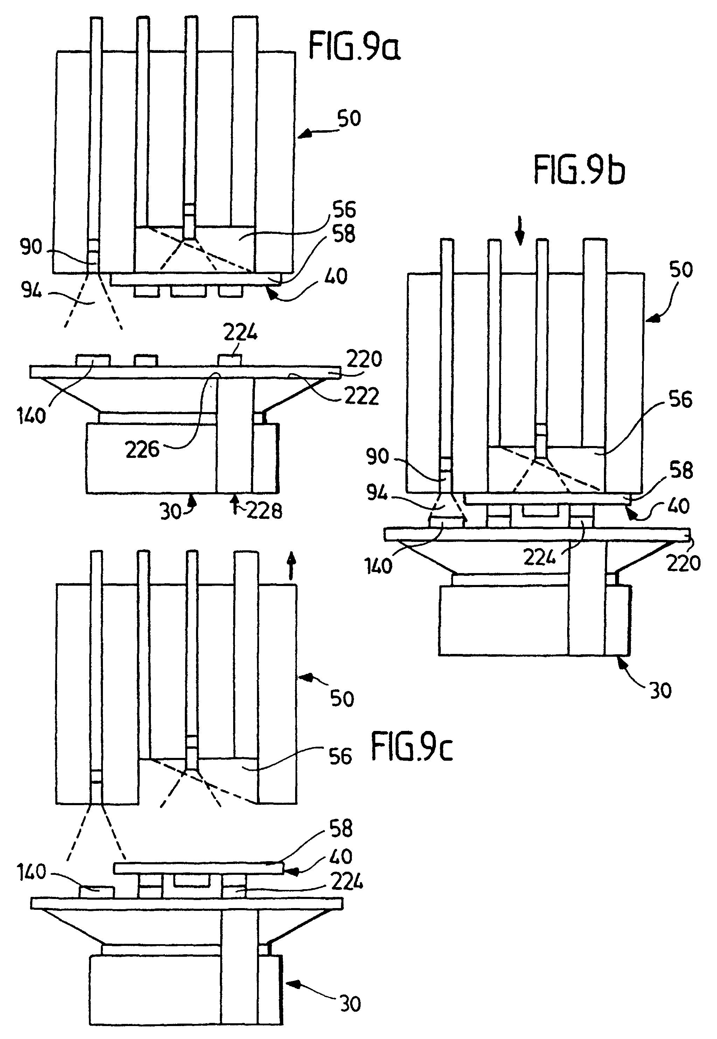

Nach dem Abtrag von Material in dem Flächenbereich 162 läßt sich wiederum mittels der Gesamtsteuerung 130 und der Steuerung 120 der Baugruppenträger 20₁ weiterbewegen zur nächsten Station, nämlich zur Beschichtungsstation 28, in welcher, wie in Fig. 8 dargestellt, ein Schichtauftrag beispielsweise in dem Flächenbereich 162 erfolgen soll. Hierzu erfolgt in gleicher Weise, wie bereits im Zusammenhang mit der Abtragstation 26 beschrieben, eine exakte Positionierung der gesamten Baugruppe 40 mittels einer ebenfalls an der Beschichtungsstation 28 vorgesehenen Positionsmarkierung 140 mit ebenfalls gleichzeitig erfolgender Korrektur entsprechend dem Ergebnis der Eichung in der Meßstation 24.

Ferner ist über einer Austrittsöffnung 210 für eine Laserstrahlung 212 der Beschichtungsstation 28 ein Träger 214 vorgesehen, welcher die auf der Baugruppe 40 aufzutragenden Schichtsegmente 216 aufweist. Durch Positionierung eines auf die Baugruppe 40 zu übertragenden Schichtsegments 216₁, in Fig. 8 punktiert dargestellt, über der Austrittsöffnung 210 für den Laserstrahl 212 und entsprechender Positionierung des Flächenbereichs 162 auf einer der Austrittsöffnung 210 gegenüberliegenden Seite des Schichtsegments 216 besteht die Möglichkeit, mit dem Laserstrahl 212 das gesamte Schichtsegment 216₁ auf den Flächenbereich 162 berührungslos zu transformieren, wobei ein Transformationsprozeß ähnlich den bekannten LIFT-Prozessen erfolgt, allerdings mit dem Unterschied, daß die Laserstrahlung 212 durch einen oder mehrere Pulse mit Pulsdauern im Pikosekundenbereich gebildet wird, so daß im Gegensatz zu den LIFT-Prozessen kein Erschmelzen des Materials des Schichtsegments 216₁ erfolgt, sondern dieses als Ganzes übertragen wird und somit eine exakte Positionierung und formtreue Übertragung desselben möglich ist. Diese Vorteile ergeben sich dadurch, daß sich an der Grenzfläche zwischen dem Schichtsegment 216 und dem Träger 214 aufgrund des kurzen Laserpulses Dampf bildet, der für einen schnellen Transfer des gesamten Schichtsegments 216₁ auf den Flächenbereich 162 verantwortlich ist, welcher wiederum zu einer guten Haftung des Schichtsegments 216 im Flächenbereich 162 beiträgt.

Vorzugsweise hat die Laserstrahlung 212 in gleicher Weise wie die Laserstrahlung 164 ein rechteckförmiges Strahlprofil 182, das sich durch die Strahlformungsoptik 180 erhalten läßt.

Durch Bewegen des Trägers 214 kann beispielsweise in der Beschichtungsstation 28 eine derartige Beschichtung der Baugruppe 40 mehrfach erfolgen.

Im Anschluß an das Beschichten der Baugruppe 40, beispielsweise beiderseits der Meßmarkierung 148, läßt sich eine derartige Baugruppe 40 durch die Gesamtsteuerung 130 und die Steuerung 120 des jeweiligen Baugruppenträgers 20₁ durch Bewegen des Baugruppenträgers 20₁ zur Montagestation 30 transportieren, wobei, wie in Fig. 9 dargestellt, eine Montage der Baugruppe 40 auf einer in der Montagestation 30 vorgesehenen Grundbaugruppe 220 möglich ist.

Die Grundbaugruppe 220 trägt ebenfalls die Positionsmarkierung 140 und erlaubt somit eine exakte Positionierung des Greiferkopfes 50 relativ zu dieser. Ferner liegt die Grundbaugruppe 220 auf einer Positionierungsfläche 222 der Montagestation 30, daß ein mit dem transferierten Schichtsegment 216 durch Fügen zu verbindendes Schichtelement 224 über einer Austrittsöffnung 226 für einen Fügelaserstrahl 228 liegt. Durch exaktes Aufsetzen der Baugruppe 40 auf die Grundbaugruppe 220 derart, daß das Schichtsegment 216 auf dem Schichtelement 224 aufliegt, wie in Fig. 9b dargestellt, und Einschalten des Fügelaserpulses 228 ist eine Verschweißung des Schichtelements 224 der Grundbaugruppe 220 mit dem Schichtsegment 216 der Baugruppe 40 möglich und somit eine Verbindung der Baugruppe 40 mit der Grundbaugruppe 220, wie in Fig. 9b dargestellt. Nach Verbinden mit der Grundbaugruppe 220 mit der Baugruppe 240 ist, wie in Fig. 9c dargestellt, durch Belüften der Vakuumkammer 56 ein Lösen der Baugruppe 40 von dem Greiferkopf 50 möglich, so daß die exakt auf der Grundbaugruppe 220 positionierte und mit dieser verbundene Baugruppe 40 nunmehr auf der Montagestation 30 liegt und diese Einheit dann durch beliebige weitere Transporteinheiten oder auch durch einen der Baugruppenträger 20 abtransportierbar ist.

## Patentansprüche

1. Verfahren zum Durchführen von Arbeitsschritten an miniaturisierten Baugruppen (40), die von einem mit einer Halteeinrichtung (50) versehenen Baugruppenträger (20) gehalten sind, in mindestens einer Arbeitsstation (22, 24, 26, 28, 30), wobei die Baugruppe (40) mit dem Baugruppenträger (20) zur Durchführung der Arbeitsschritte zu mehreren Arbeitsstationen (22, 24, 26, 28, 30) gebracht wird und durch Relativbewegung zwischen dem Baugruppenträger (20) und der jeweils einen der mehreren Arbeitsstationen (22, 24, 26, 28, 30) zum Durchführen eines der Arbeitsschritte exakt positioniert wird und wobei für die Durchführung der Arbeitsschritte die Positionierung der Baugruppe (40) gegenüber dem Baugruppenträger (20) aufrecht erhalten wird,
**dadurch gekennzeichnet, daß** eine Position der Baugruppe (40) relativ zum Baugruppenträger (20) durch eine am Baugruppenträger (20) angeordnete und eine Position der Baugruppe (40) erfassende Positioniereinrichtung (68) ermittelt wird und daß in einer Arbeitsstation (22, 24, 26, 28) eine gesteuerte Relativpositionierung zwischen Baugruppenträger (20) und Arbeitsstation (22, 24, 26, 28, 30), oder Baugruppenträger (20) und weiterer Baugruppe (220) oder Arbeitsstation (24) und Baugruppe (40) geführt durch an diesen angeordnete Positionserkennungselemente (98, 146, 140, 148, 58), durchgeführt wird.

2. Verfahren nach Anspruch 1, **dadurch gekennzeichnet, daß** bei Durchführung einer Folge von Arbeitsschritten die Baugruppe (40) stets von der Halteeinrichtung (50) des Baugruppenträgers (20) gehalten wird.

3. Verfahren nach Anspruch 2, **dadurch gekennzeichnet, daß** die Folge von Arbeitsschritten mechanisch berührungslos durchgeführt wird.

4. Verfahren nach Anspruch 3, **dadurch gekennzeichnet, daß** die Arbeitsschritte mittels elektromagnetischer Strahlung durchgeführt werden.

5. Verfahren nach einem der voranstehenden Ansprüche, **dadurch gekennzeichnet, daß** als einer der Arbeitsschritte eine Feinpositionierung der Baugruppe (40) durchgeführt wird.

6. Verfahren nach Anspruch 5, **dadurch gekennzeichnet, daß** beim Arbeitsschritt der Feinpositionierung eine exakte Position der Baugruppe (40) relativ zum Baugruppenträger (20) ermittelt und für nachfolgende Arbeitsschritte zur Verfügung gestellt wird.

7. Verfahren nach einem der voranstehenden Ansprüche, **dadurch gekennzeichnet, daß** in einer der Arbeitsstationen ausschließlich berührungslose Arbeitsschritte durchgeführt werden.

8. Verfahren nach Anspruch 7, **dadurch gekennzeichnet, daß** jeder berührungslose Arbeitsschritt mittels elektromagnetischer Strahlung durchgeführt wird.

9. Verfahren nach Anspruch 8, **dadurch gekennzeichnet, daß** jeder Arbeitsschritt mit räumlich im wesentlichen gleichmäßiger Energiedichteverteilung durchgeführt wird.

10. Verfahren nach Anspruch 8 oder 9, **dadurch gekennzeichnet, daß** jeder Arbeitsschritt mittels Laserstrahlung (164, 212) durchgeführt wird.

11. Verfahren nach Anspruch 10, **dadurch gekennzeichnet, daß** ein Strahlprofil (182) des Laserstrahls (164, 212) rechteckig oder quadratisch ausgebildet ist.

12. Verfahren nach Anspruch 10 oder 11, **dadurch gekennzeichnet, daß** jeder Arbeitsschritt mittels gepulster Laserstrahlung (164, 212) durchgeführt wird.

13. Verfahren nach einem der voranstehenden Ansprüche, **dadurch gekennzeichnet, daß** in einer der Arbeitsstationen (28) ein Schichtauftrag auf die Baugruppe (40) mittels Laserstrahlung (212) durchgeführt wird.

14. Verfahren nach einem der voranstehenden Ansprüche, **dadurch gekennzeichnet, daß** in einer der Arbeitsstationen (26) ein Materialabtrag von der Baugruppe (40) mittels Laserstrahlung (164) durchgeführt wird.

15. Verfahren nach einem der voranstehenden Ansprüche, **dadurch gekennzeichnet, daß** in einer der Arbeitsstationen (30) eine Fügeverbindung auf der Baugruppe (40) mittels Energiezufuhr durch elektromagnetische Strahlung hergestellt wird.

16. Verfahren nach einem der voranstehenden Ansprüche, **dadurch gekennzeichnet, daß** ein Baugruppenträger (20) entsprechend einer festgelegten Folge von einer Arbeitsstation (22, 24, 26, 28, 30) zur anderen bewegt wird.

17. Verfahren nach Anspruch 16, **dadurch gekennzeichnet, daß** mehrere Baugruppenträger (20) gleichzeitig mit jeweils einer der mehreren Arbeitsstationen (22, 24, 26, 28, 30) zusammenwirken.

18. Verfahren nach Anspruch 16 oder 17, **dadurch gekennzeichnet, daß** die Baugruppenträger (20) relativ zu einer Grundeinheit bewegt werden können.

19. Verfahren nach Anspruch 18, **dadurch gekennzeichnet, daß** die Baugruppenträger (20) auf der Grundeinheit (18) entlang beliebig vorgebbarer Pfade bewegt werden können.

20. Verfahren nach einem der voranstehenden Ansprüche, **dadurch gekennzeichnet, daß** die Baugruppenträger (20) berührungslos mit Steuerinformationen versorgt werden.

21. Verfahren nach Anspruch 20, **dadurch gekennzeichnet, daß** die Baugruppenträger berührungslos positionsgesteuert werden.

22. Verfahren nach einem der voranstehenden Ansprüche, **dadurch gekennzeichnet, daß** die Baugruppenträger (20) berührungslos mit Energie versorgt werden.

23. Verfahren nach einem der voranstehenden Ansprüche, **dadurch gekennzeichnet, daß** die Baugruppenträger (20) Meßdaten berührungslos übermitteln.

24. Einrichtung zum Durchführen von Arbeitsschritten an miniaturisierten Baugruppen, insbesondere nach einem der Ansprüche 1 bis 21, umfassend einen mit einer Halteeinrichtung (50) zum Halten der Baugruppen (40) versehenen Baugruppenträger (20) und mehrere Arbeitsstationen (22, 24, 26, 28, 30) zum Durchführen jeweils mindestens eines Arbeitsschritts, wobei der Baugruppenträger (20) so bewegbar ist, daß bei den mehreren Arbeitsstationen (22, 24, 26, 28, 30) die Baugruppe (40) zur Durchführung der Arbeitsschritte durch Relativbewegung zwischen Baugruppenträger (20) und Arbeitsstation (22, 24, 26, 28, 30) exakt positionierbar ist und die Baugruppe (40) mit der Halteeinrichtung (50) für die Durchführung der Arbeitsschritte in einer einzigen Relativposition zum Baugruppenträger (20) fixierbar ist, **dadurch gekennzeichnet, daß** eine Position der Baugruppe (40) relativ zum Baugruppenträger (20) durch eine am Baugruppenträger (20) angeordnete und eine Position der Baugruppe (40) erfassende Positioniereinrichtung (68) ermittelbar ist und daß in einer Arbeitsstation (22, 24, 26, 28) eine gesteuerte Relativpositionierung zwischen Baugruppenträger (20) und Arbeitsstation (22, 24, 26, 28, 30), oder Baugruppenträger (20) und weiterer Baugruppe (220) oder Arbeitsstation (24) und Baugruppe (40) geführt durch an diesen angeordnete Positionserkennungselemente (98, 146, 140, 148, 58), durchgeführbar ist.

25. Einrichtung nach Anspruch 24, **dadurch gekennzeichnet, daß** die Baugruppe (40) an einem als Halteeinrichtung dienenden Greiferkopf (50) des Baugruppenträgers (20) fixierbar ist.

26. Einrichtung nach Anspruch 25, **dadurch gekennzeichnet, daß** der Greiferkopf (50) einen Vakuumgreifer (53) für die Baugruppe (40) aufweist.

27. Einrichtung nach Anspruch 26, **dadurch gekennzeichnet, daß** in dem Vakuumgreifer (53) eine Positioniereinrichtung (68) für die Baugruppe (40) integriert ist.

28. Einrichtung nach Anspruch 27, **dadurch gekennzeichnet, daß** die Positioniereinrichtung (68) eine einer Vakuumkammer (56) des Vakuumgreifers (53) zugeordnete Markierung (72) auf der Baugruppe (40) erkennend ausgebildet ist.

29. Einrichtung nach einem der Ansprüche 24 bis 28, **dadurch gekennzeichnet, daß** der Greiferkopf (50) und mindestens eine der Arbeitsstationen (24, 26, 28, 30) miteinander zusammenwirkende Positionserkennungselemente (90, 140) aufweisen, mit welchen der Greiferkopf (50) exakt zur Arbeitsstation (24, 26, 28, 30) positionierbar ist.

30. Einrichtung nach einem der Ansprüche 24 bis 29, **dadurch gekennzeichnet, daß** der Baugruppenträger (20) eine Antriebseinheit (102) aufweist, mit welcher dieser relativ zu einer Grundeinheit (10) bewegbar ist.

31. Einrichtung nach einem der Ansprüche 24 bis 30, **dadurch gekennzeichnet, daß** der Baugruppenträger (20) eine Koppeleinheit (104) aufweist, mit welcher Energie in den Baugruppenträger (20) einkoppelbar ist.

32. Einrichtung nach einem der Ansprüche 24 bis 31, **dadurch gekennzeichnet, daß** der Baugruppenträger (20) Positioniereinheiten (108, 110, 112, 113, 114) aufweist, mit welchen der Greiferkopf (50) relativ zu einem Grundelement (46) des Baugruppenträgers (20) bewegbar ist.

33. Einrichtung nach Anspruch 32, **dadurch gekennzeichnet, daß** der Baugruppenträger das Grundelement (46) und einen den Greiferkopf (50) tragenden Ausleger (44) aufweist.

34. Einrichtung nach einem der Ansprüche 24 bis 33, **dadurch gekennzeichnet, daß** der Baugruppenträger (20) eine Steuerung (120) aufweist, mit welcher der Greiferkopf (50) positionierbar ist.

35. Einrichtung nach Anspruch 34, **dadurch gekennzeichnet, daß** die Steuerung (120) mit einer Gesamtsteuerung (130) kommuniziert.

36. Einrichtung nach Anspruch 35, **dadurch gekennzeichnet, daß** die Steuerung (120) mittels berührungsloser Informationsübertragung mit der Gesamtsteuerung (130) kommuniziert.

37. Einrichtung nach einem der Ansprüche 24 bis 36, **dadurch gekennzeichnet, daß** eine der Arbeitsstationen (26, 28) mit einer Laserstrahlungsquelle (106) versehen ist, mit welcher die zur Durchführung des Arbeitsschritts in dieser erforderliche Laserstrahlung (164, 212) erzeugbar ist.

38. Einrichtung nach Anspruch 37, **dadurch gekennzeichnet, daß** die Laserstrahlung aus einer einer in dieser Arbeitsstation (26, 28) positionierten Baugruppe (40) zugewandten Austrittsöffnung (160, 210) austritt.

39. Einrichtung nach Anspruch 38, **dadurch gekennzeichnet, daß** in einer der Arbeitsstationen (28) zwischen der Austrittsöffnung (210) für die Laserstrahlung (212) und der Baugruppe (40) ein mit der Baugruppe (40) zu verbindendes Element (216) positionierbar ist.

40. Einrichtung nach einem der Ansprüche 37 bis 39, **dadurch gekennzeichnet, daß** die Laserstrahlungsquelle (166) gepulste Laserstrahlung erzeugt.

41. Einrichtung nach Anspruch 40, **dadurch gekennzeichnet, daß** die Laserstrahlungsquelle (166) Laserstrahlung (164, 212) mit Pulsdauern im Pikosekundenbereich erzeugt.

42. Einrichtung nach Anspruch 40 oder 41 **dadurch gekennzeichnet, daß** die Laserstrahlungsquelle (166) Pulse mit einem rechteckigen Strahlprofil (182) erzeugt.

## Claims

1. A method of carrying out working steps on miniaturised modules (40), which are held by a module carrier (20) provided with a holding device (50), in at least one work station (22, 24, 26, 28, 30), the module (40) being moved with the module carrier (20) to a plurality of work stations (22, 24, 26, 28, 30) for the purposes of carrying out the working steps, and being precisely positioned for carrying out one of the working steps by means of a relative movement between the module carrier (20) and the currently relevant one of the plurality of workstations (22, 24, 26, 28, 30), and the positioning of the module (40) relative to the module carrier being maintained for carrying out the working steps, **characterised in that** there is determined a position of the module (40) relative to the module carrier (20) by a positioning device (68) arranged on the module carrier (20) and detecting a position of the module (40) and **in that** in a work station (22, 24, 26, 28) there is undertaken a controlled relative positioning between module carrier (20) and work station (22, 24, 26, 28, 30), or module carrier (20) and further modules (220) or work station (24) and module (40) guided by position detecting elements (98, 146, 140, 148, 58) arranged thereon.

2. A method in accordance with Claim 1, **characterised in that** the module (40) continues to be held by the holding device (50) in the module carrier (20) whilst carrying out a sequence of working steps.

3. A method in accordance with Claim 2, **characterised in that** the sequence of working steps is effected in a mechanically non-contact making manner.

4. A method in accordance with Claim 3, **characterised in that** the working steps are carried out by means of electromagnetic radiation.

5. A method in accordance with any of the preceding Claims, **characterised in that** a process of fine positioning the module (40) is carried out as one of the working steps.

6. A method in accordance with Claim 5, **characterised in that** an exact position of the module (40) relative to the module carrier (20) is determined during the fine positioning working step and **in that** this position is made available for the subsequent working steps.

7. A method in accordance with any of the preceding Claims, **characterised in that** exclusively non-contact making working steps are carried out in one of the work stations.

8. A method in accordance with Claim 7, **characterised in that** each of the non-contact making working steps is carried out by means of electromagnetic radiation.

9. A method in accordance with Claim 8, **characterised in that** each working step is carried out with substantially spatially uniform energy density distribution.

10. A method in accordance with Claim 8 or 9, **characterised in that** each working step is carried out by means of laser radiation (164, 212).

11. A method in accordance with Claim 10, **characterised in that** a beam profile (182) of the laser beam (164, 212) is rectangular or square.

12. A method in accordance with Claim 10 or 11, **characterised in that** each working step is carried out by means of pulsed laser radiation (164, 212).

13. A method in accordance with any of the preceding Claims, **characterised in that** a process of applying a layer to the module (14) is carried out by means of laser radiation (212) in one of the work stations (28).

14. A method in accordance with any of the preceding Claims, **characterised in that** a process of removing material from the module (40) is carried out by means of laser radiation (164) in one of the work stations (26).

15. A method in accordance with any of the preceding Claims, **characterised in that** a jointed cofinection to the module (40) is produced by means of a process of supplying energy by electromagnetic radiation in one of the workstations (30).

16. A method in accordance with any of the preceding Claims, **characterised in that** a module carrier (20) is moved from one work station (22, 24, 26, 28, 30) to another in correspondence with a defined sequence.

17. A method in accordance with Claim 16, **characterised in that** a plurality of module carriers (20) co-operate simultaneously with respective ones of the plurality of work stations (22, 24, 26, 28, 30).

18. A method in accordance with Claim 16 or 17, **characterised in that** the module carriers (20) are movable relative to a base unit.

19. A method in accordance with Claim 18, **characterised in that** the module carriers (20) can be moved along arbitrary predefined paths on the base unit (18).

20. A method in accordance with any of the preceding Claims, **characterised in that** the module carriers (20) are supplied with control information in non-contact making manner.

21. A method in accordance with Claim 20, **characterised in that** the positioning of the module carriers is controlled in non-contact making manner.

22. A method in accordance with any of the preceding Claims, **characterised in that** the module carriers (20) are supplied with energy in non-contact making manner.

23. A method in accordance with any of the preceding Claims, **characterised in that** the module carriers (20) transfer test data in non-contact making manner.

24. A device for carrying out working steps on miniaturised modules, especially in accordance with any of Claims 1 to 21, comprising a module carrier (20) provided with a holding device (50) for holding the modules (40) and a plurality of work stations (22,24 26, 28, 30) for carrying out at least one respective working step, the module carrier (20) being movable in such a manner that the module (40) is precisely positionable by virtue of a relative movement of the module carrier (20) and the work station (22, 24, 26, 28, 13) for the purposes of carrying out the working steps in the plurality of work stations (22, 24, 26, 28, 30), and the module (40) being adapted to be fixed by the holding device (50) in a single relative position with respect to the module carrier (20) for carrying out the working steps, **characterised in that** a position of the module (40) relative to the module carrier (20) is determinable by a positioning device (68) arranged on the module carrier (20) and detecting a position of the module (40) and **in that** in a work station (22, 24, 26, 28) there can be undertaken a controlled relative positioning between module carrier (20) and work station (22, 24, 26, 28, 30), or module carrier (20) and further modules (220) or work station (24) and module (40) guided by position detecting elements (98, 146, 140, 148, 58) arranged thereon.

25. A device in accordance with Claim 24, **characterised in that** the module (40) is adapted to be fixed on a holding device in the form of a gripper head (50) of the module carrier (20).

26. A device in accordance with Claim 25, **characterised in that** the gripper head (50) comprises a vacuum gripper (53) for the module (40).

27. A device in accordance with Claim 26, **characterised in that** a positioning device (68) for the module (40) is integrated in the vacuum gripper (53).

28. A device in accordance with Claim 27, **characterised in that** the positioning device (68) is formed such as to detect a marking (72) on the module (40) that is associated with a vacuum chamber (56) of the vacuum gripper (53).

29. A device in accordance with any of Claims 24 to 28, **characterised in that** the gripper head (50) and at least one of the work stations (24, 26, 28, 30) comprise mutually cooperating positioning elements (90; 140) with which the gripper head (50) is precisely positionable with respect to the work station (24, 26, 28, 30).

30. A device in accordance with any of Claims 24 to 29, **characterised in that** the module carrier (20) comprises a driver unit (102) with which it is movable relative to a base unit (10).

31. A device in accordance with any of Claims 24 to 30, **characterised in that** the module carrier (20) comprises a coupling unit (104) with which energy is adapted to be coupled into the module carrier (20).

32. A device in accordance with any of Claims 24 to 31, **characterised in that** the module carrier (20) comprises positioning units (108, 110, 112, 113, 114) with which the gripper head (50) is movable relative to a base element (46) of the module carrier (20).

33. A device in accordance with Claim 32, **characterised in that** the module carrier comprises the base element (46) and an extension arm (44) which supports the gripper head (50).

34. A device in accordance with any of Claims 24 to 33, **characterised in that** the module carrier (20) comprises a control system (120) with which the gripper head (50) is positionable.

35. A device in accordance with Claim 34, **characterised in that** the control system (120) communicates with an overall control system (130).

36. A device in accordance with Claim 35, **characterised in that** the control system (120) communicates with the overall control system (130) by means of a non-contact making transfer of information.

37. A device in accordance with any of Claims 24 to 36, **characterised in that** one of the work stations (26, 28) is provided with a source of laser radiation (106) with which the laser radiation (164, 212) that is required for carrying out the working step therein is producible.

38. A device in accordance with Claim 37, **characterised in that** the laser radiation emerges from an outlet opening (160, 210) which faces a module (40) positioned in this work station (26, 28).

39. A device in accordance with Claim 38, **characterised in that** an element (216) that is to be connected to the module (40) is positionable in one of the work stations (28) between the outlet opening (210) for the laser radiation (212) and the module (40).

40. A device in accordance with any of Claims 37 to 39, **characterised in that** the source of laser radiation (166) produces pulsed laser radiation.

41. A device in accordance with Claim 40, **characterised in that** the source of laser radiation (166) produces laser radiation (164, 212) having pulse durations in the pico-second range.

42. A device in accordance with Claim 40 or 41, **characterised in that** the source of laser radiation (166) produces pulses having a rectangular beam profile (182).

## Revendications

1. Procédé de mise en oeuvre d'étapes de travail sur des modules miniaturisés (40), qui sont maintenus par un support de module (20) muni d'un dispositif de retenue (50), dans au moins un poste de travail (22, 24, 26, 28, 30), le module (40) étant amené avec le support de module (20) en direction de plusieurs postes de travail (22, 24, 26, 28, 30) pour la mise en oeuvre des étapes de travail et étant positionné avec précision par mouvement relatif entre le support de module (20) et l'un des plusieurs postes de travail (22, 24, 26, 28, 30) pour la mise en oeuvre de l'une des étapes de travail, et le module (40) étant maintenu en position sans changement par rapport au support de module (20) pour la mise en oeuvre des étapes de travail, **caractérisé en ce qu'**une position du module (40) par rapport au support de module (20) est déterminée par une unité de positionnement (68), agencée sur le support de module (20) et détectant une position du module (40), et **en ce que**, dans un poste de travail (22, 24, 26, 28), un positionnement relatif contrôlé est effectué entre le support de module (20) et le poste de travail (22, 24, 26, 28, 30) ou entre le support de module (20) et un module supplémentaire (220) ou entre le poste de travail (24) et le module (40) au moyen des éléments de détection de position (98, 146, 140, 148, 58) agencés sur ceux-ci.

2. Procédé selon la revendication 1, **caractérisé en ce que** lors de la mise en oeuvre d'une série d'étapes de travail, le module (40) est toujours maintenu par le dispositif de retenue (50) du support de module (20).

3. Procédé selon la revendication 2, **caractérisé en ce que** la série d'étapes de travail est effectuée mécaniquement sans contact.

4. Procédé selon la revendication 3, **caractérisé en ce que** les étapes de travail sont effectuées au moyen d'un rayonnement électromagnétique.

5. Procédé selon une des revendications précédentes, **caractérisé en ce que** l'une des étapes de travail consiste à réaliser le positionnement précis du module (40).

6. Procédé selon la revendication 5, **caractérisé en ce que**, pendant l'étape de positionnement précis, une position exacte du module (40) par rapport au support de module (20) est déterminée et est utilisée pour les étapes de travail suivantes.

7. Procédé selon une des revendications précédentes, **caractérisé en ce que** dans l'un des postes de travail sont effectuées exclusivement des étapes de travail sans contact.

8. Procédé selon la revendication 7, **caractérisé en ce que** chaque étape de travail sans contact est effectuée au moyen d'un rayonnement électromagnétique.

9. Procédé selon la revendication 8, **caractérisé en ce que** chaque étape de travail est effectuée avec une répartition de la densité d'énergie sensiblement uniforme dans l'espace.

10. Procédé selon la revendication 8 ou 9, **caractérisé en ce que** chaque étape de travail est effectuée au moyen du rayonnement d'un laser (164, 212).

11. Procédé selon la revendication 10, **caractérisé en ce que** le faisceau laser (164, 212) présente un profil (182) rectangulaire ou carré.

12. Procédé selon la revendication 10 ou 11, **caractérisé en ce que** chaque étape de travail est effectuée au moyen d'un rayonnement laser (164, 212) en régime pulsé.

13. Procédé selon une des revendications précédentes, **caractérisé en ce que**, dans l'un des postes de travail (28), le module (40) est revêtu d'une couche au moyen d'un rayonnement laser (212).

14. Procédé selon une des revendications précédentes, **caractérisé en ce que**, dans l'un des postes de travail (26), est effectué un enlèvement de matière sur le module (40) au moyen d'un rayonnement laser (212).

15. Procédé selon une des revendications précédentes, **caractérisé en ce que**, dans l'un des postes de travail (30), un assemblage bord à bord est réalisé sur le module (40) par un apport d'énergie, fourni par un rayonnement électromagnétique.

16. Procédé selon une des revendications précédentes, **caractérisé en ce qu'**un support de module (20) est déplacé d'un poste de travail (22, 24, 26, 28, 30) vers un autre dans un ordre déterminé.

17. Procédé selon la revendication 16, **caractérisé en ce que** plusieurs supports de module (20) coopèrent simultanément avec respectivement l'un des plusieurs postes de travail (22, 24, 26, 28, 30).

18. Procédé selon la revendication 16 ou 17, **caractérisé en ce que** les supports de module (20) peuvent se déplacer par rapport à une unité de base.

19. Procédé selon la revendication 18, **caractérisé en ce que** les supports de module (20) sur l'unité de base (18) peuvent se déplacer le long de voies à prédéfinir de manière quelconque.

20. Procédé selon une des revendications précédentes, **caractérisé en ce que** les supports de module (20) sont actionnés sans contact par des informations de commande.

21. Procédé selon la revendication 20, **caractérisé en ce que** la position des supports de module est commandée en sans contact.

22. Procédé selon une des revendications précédentes, **caractérisé en ce que** les supports de module (20) sont alimentés en énergie sans contact.

23. Procédé selon une des revendications précédentes, **caractérisé en ce que** les supports de module (20) transmettent sans contact des données de mesure.

24. Dispositif destiné à la mise en oeuvre d'étapes de travail sur des modules miniaturisés, en particulier selon l'une quelconque des revendications 1 à 21, comprenant un support de module (20), muni d'un dispositif de retenue (50) pour maintenir les modules (40), et plusieurs postes de travail (22, 24, 26, 28, 30) destinés chacun à la mise en oeuvre d'au moins une étape de travail, le support de module (20) pouvant se déplacer de telle sorte que dans la pluralité de postes de travail (22, 24, 26, 28, 30) le module (40) peut être positionné avec précision par un mouvement relatif entre le support de module (20) et le poste de travail (22, 24, 26, 28, 30) pour la mise en oeuvre des étapes de travail, et le module (40) avec le dispositif de retenue (50) peut être bloqué dans une seule position relative par rapport au support de module (20) pour la mise en oeuvre des étapes de travail, **caractérisé en ce qu'**une position du module (40) peut être déterminée par une unité de positionnement (68) agencée sur le support de module (20) et enregistrant une position du module (40) et **en ce que**, dans le poste de travail (22, 24, 26, 28), un positionnement relatif contrôlé est effectué entre le support de module (20) et le poste de travail (22, 24, 26, 28, 30) ou entre le support de module (20) et un module supplémentaire (220) ou entre le poste de travail (24) et le module (40) au moyen des éléments de détection de position (98, 146, 140, 148, 58) agencés sur ceux-ci.

25. Dispositif selon la revendication 24, **caractérisé en ce que** le module (40) peut être fixé contre une tête de préhension (50), faisant fonction de dispositif de retenue, dans le support de module (20).

26. Dispositif selon la revendication 25, **caractérisé en ce que** la tête de préhension (50) est munie d'une pince sous vide (53) pour le module (40).

27. Dispositif selon la revendication 26, **caractérisé en ce qu'**une unité de positionnement (68) pour le module (40) est intégrée dans la pince sous vide (53).

28. Dispositif selon la revendication 27, **caractérisé en ce que** l'unité de positionnement (68) est conçue de manière à détecter sur le module (40) un repère (72) associé à une chambre sous vide (56) de la pince sous vide (53).

29. Dispositif selon l'une quelconque des revendications 24 à 28, **caractérisé en ce que** la tête de préhension (50) et au moins un des postes de travail (24, 26, 28, 30) comportent des éléments de détection de position (90, 140) coopérant entre eux et permettant de positionner la tête de préhension (50) avec précision par rapport au poste de travail (24, 26, 28, 30).

30. Dispositif selon l'une quelconque des revendications 24 à 29, **caractérisé en ce que** le support de module (20) comporte une unité d'entraînement (102), par laquelle ledit support de module peut être déplacé par rapport à une unité de base (10).

31. Dispositif selon l'une quelconque des revendications 24 à 30, **caractérisé en ce que** le support de module (20) comporte une unité de connexion (104), par laquelle l'énerg est acheminée dans le support de module (20).

32. Dispositif selon l'une quelconque des revendications 24 à 31, **caractérisé en ce que** le support de module (20) comporte des unités de positionnement (108, 110, 112, 113, 114), par lesquelles la tête de préhension (50) peut se déplacer par rapport à un élément de base (46) du support de module (20).

33. Dispositif selon la revendication 32, **caractérisé en ce que** le support de module est muni de l'élément de base (46) et d'un bras (44) portant la tête de préhension (50).

34. Dispositif selon l'une quelconque des revendications 24 à 33, **caractérisé en ce que** le support de module (20) est muni d'une commande (120), par laquelle la tête de préhension (50) est positionnable.

35. Dispositif selon la revendication 34, **caractérisé en ce que** la commande (120) communique avec une commande générale (130).

36. Dispositif selon la revendication 35, **caractérisé en ce que** la commande (120) communique avec la commande générale (130) par l'intermédiaire d'une transmission d'informations sans contact.

37. Dispositif selon l'une quelconque des revendications 24 à 36, **caractérisé en ce que** l'un des postes de travail (26, 28) est muni d'une source de rayonnement laser (106), par laquelle peut être généré le faisceau laser (164, 212) nécessaire à la mise en oeuvre de l'étape de travail dans ledit poste de travail.

38. Dispositif selon la revendication 37, **caractérisé en ce que** le faisceau laser est projeté hors d'un orifice de sortie (160, 210) orienté vers un module (40) positionné dans ce poste de travail (26, 28).

39. Dispositif selon la revendication 38, **caractérisé en ce que**, dans l'un des postes de travail (28), un élément (216) à assembler avec le module (40) peut être positionné entre l'orifice de sortie (210) pour le faisceau laser (212) et le module (40).

40. Dispositif selon l'une quelconque des revendications 37 à 39, **caractérisé en ce que** la source de rayonnement laser (166) génère un faisceau laser en régime pulsé.

41. Dispositif selon la revendication 40, **caractérisé en ce que** la source de rayonnement laser (166) génère un faisceau laser avec des durées d'impulsion dans le domaine des picosecondes.

42. Dispositif selon la revendication 40 ou 41, **caractérisé en ce que** la source de rayonnement laser (166) génère des impulsions avec un profil de rayonnement (182) rectangulaire.
